# EUROPEAN PATENT APPLICATION

(11) **EP 4 576 096 A1**
(43) Date of publication of application: **25.06.2025**
(21) Application number: 23307288.3
(22) Date of filing: 20.12.2023
(51) Int. Cl.: G11C 16/22, G11C 16/26, G11C 7/24

(54) **SECURE NON-VOLATILE MEMORY**

(71) Applicant: THALES DIS FRANCE SAS, 92190 Meudon (FR)
(72) Inventor: NAURA, David, 13100 Aix en Provence (FR); BOUR, Laureline, 87470 Saint Maximin La Sainte Baume (FR)
(74) Representative: Bricks, Amélie

(57) **Abstract**

The invention relates to a non-volatile memory circuit (300) comprising a plurality of memory cells (MCj,i), a plurality of bit lines (BLi) and a plurality of word lines (WLj to WLj+2), each memory cell (MCj,i) comprising a floating gate transistor (Tfg) for memorizing a bit value and being located at the intersection of a bit line (BLi) and of a word line (WLj), said non-volatile memory circuit (300) comprising a polarization circuit (360) for polarizing the bit lines (BLi) with a constant current, and reading amplifiers (370) connected to bit lines (BLi) for reading the value of memory cells (MCj,i) selected by one of the word lines (WLj). The memory circuit (300) further comprises an attack detector (390) comprising at least one detection circuit (391) having a first input terminal connected to at least one bit line (BLi) for detecting an abnormal voltage on the bit line (BLi) and for providing an alarm signal (ALARM) on an output terminal when the abnormal voltage is detected.

## Description

### Technical Field

The invention relates to a secure non-volatile memory and more particularly non-volatile memory using floating gate transistor.

### Background Art

Non-volatile memories are commonly used for memorizing information without power supply. Amongst the different categories of non-volatile memories, memories with floating gate transistor allow to be programmable and erasable, like Flash memories or EEPROMs (Electrically Erasable Programmable Read Only Memory).

One use of Flash or EEPROM memories is the storing security data, in particular passwords but also secure programs for making strong authentications. Such kind of memories is commonly used in many products using secure element like smart cards, smartphones, computers, or any communicating electronic device that should be securely connected. Typically, such kind of memories are embedded in a microcontroller component making a verification of password in such a way the password never goes out of the component. Nevertheless, there are some methods for retrieving the password from such component.

One method consists in a direct access to the memory after removing protection resin from the component. Once the memory is naked, the memory can be accessed by thin probe or by laser. In such a way to avoid a direct reading of the memory, the memory can be scrambled or encoded.

Even if the memory is scrambled or encoded, a method, known as "fault attack", consists in altering the reading of the memory in such a way to cause some faults during the running of a secure program for locating where are the sensitive data.

The fault introduction can be made by laser and there is a need to stop the running of the secure program.

The French patent application FR 3 124 307 discloses a detection circuit for non-volatile memories capable of detecting a laser attack. This patent application addresses non-volatile memory for which the reading is made by a measurement of the current into the bit line. The detection circuit makes a comparison of the current into the bit line with a current threshold for detecting an attack.

For reducing size of memories, it is known to place bit line decoder between the read amplifiers and the memory cells in such a way to reduce the number of read amplifiers. Such an architecture increase the resistance of the bit line and it is preferred to have bit lines polarized at a constant current, the reading being made after a preload of the bit line at an intermediate voltage. So, the state of a selected memory cell enables a charging or a discharging of the bit line that can be compared to the preload voltage after a certain time.

The detection of laser attacks disclosed by FR 3 124 307 cannot be used with a memory using a constant current for polarizing a bit line. There is a need of additional protection circuit.

### Summary of the Invention

The invention provides a memory comprising a circuit for raising an alarm in case of detection of a laser attack during a reading of the memory. Such alarm can then be used for rebooting a microcontroller causing the aborting of the current running program.

More particularly, the invention provides a method for detecting a reading error caused by a photoelectric or radiative attack of a non-volatile memory having memory cells connected to at least one bit line, and comprising each a floating gate transistors, wherein a reading of a memory cell is made by pre-charging a bit line to a preload voltage and comparison of the bit line voltage to this preload voltage after a reading time during which a selected cell charges or discharges the bit line polarized by a constant current. The detection of a reading error is made by detection of an abnormal bit line voltage, and wherein an alarm signal is provided when an abnormal bit line voltage is detected.

According to a first embodiment, the abnormal bit line voltage is detected by comparison of the bit line voltage to a threshold voltage, said threshold voltage being a constant voltage lower than the minimum voltage that can be reached by the bit line during a normal reading operation, and wherein the abnormal bit line voltage is detected when the bit line voltage is lower than the threshold voltage. According to another embodiment, the abnormal bit line voltage is detected when the bit line voltage decreases with a slope faster than a reference slope.

The invention also provides a non-volatile memory circuit comprising a plurality of memory cells, a plurality of bit lines and a plurality of word lines, each memory cell comprising a floating gate transistor for memorizing a bit value and being located at the intersection of a bit line and of a word line, said non-volatile memory circuit comprising a polarization circuit for polarizing the bit lines with a constant current, and reading amplifiers connected to bit lines for reading the value of memory cells selected by one of the word lines. The memory circuit further comprises an attack detector comprising at least one detection circuit having a first input terminal connected to at least one bit line for detecting an abnormal voltage on the bit line and for providing an alarm signal on an output terminal when the abnormal voltage is detected.

For enabling the detection, the detection circuit can comprise a second input terminal receiving a validation signal, and wherein the alarm signal is provided only if the validation signal is activated.

For detecting an abnormal situation on several bit lines, the attack detector can comprise a plurality of detection circuits, wherein each detection circuit comprises a third input terminal, the third input terminal of a first detection circuit receiving an inactive signal, the third input terminal of each other detection circuit being connected to an output terminal of a previous detection circuit, and wherein an output terminal of a last detection circuit corresponds to an output terminal of the attack detector, in such a way that if one of the detection circuits provides an alarm signal, this alarm signal is cascaded to the output terminal of the attack detector.

According to a first embodiment, the detection circuit can comprise a comparator having two inputs and one output, one of the inputs being connected to the first input terminal and the other input receiving a threshold voltage which is a constant voltage lower than the minimum voltage that can be reached by the bit line during a normal reading operation, and wherein an abnormal voltage is detected when the bit line voltage is lower than the threshold voltage. According to a second embodiment, the detection circuit can comprise a slope detector, and wherein an abnormal voltage is detected when the bit line voltage decreases with a slope faster than a reference slope.

Preferentially, the slope detector can comprise :
- a first branch comprising at least a first logic circuit having an input connected to the bit line and having a first input threshold, a delay circuit connected to the output of the first logic circuit for delaying a transition of the first logic circuit, and
- a second branch comprising at least a second logic circuit having an input connected to the bit line and having a second input threshold lower than the first input threshold,
- a third logic circuit having one input connected to an output of the delay circuit and another input connected to an output of the second logic circuit, an output of the third logic circuit being active when a transition at the output of the second logic circuit occurs before a transition at the output of the delay circuit, and
- a latch circuit connected to the output of the third logic circuit for providing the alarm signal in response to activation of the output of the third logic circuit.

For rearming the slope detector, the latch circuit can be reset when the validation signal is inactive.

### Brief description of the Drawings

The invention will be detailed with reference to the annexed drawings in which:
Figure 1 shows a microcontroller type circuit including a non-volatile memory,
Figure 2 shows a structure of a non-volatile memory circuit according to the invention,
Figure 3 details a part of a bit line according to the invention,
Figure 4 shows a timing diagram of a reading operation in normal condition,
Figure 5 shows a timing diagram of a reading operation during a laser attack,
Figure 6 details a first embodiment of an attack detector according to the invention,
Figure 7 details a second embodiment of an attack detector according to the invention,
Figure 8 shows a timing diagram of a reading operation during a laser attack with the attack detector of figure 7.

### Detailed Description of the invention

In such a way to simplify the present specification, a same reference is used on different drawings for designing a same element or an equivalent element. In addition, only parts of the memory are shown on the drawings for avoiding a surcharge that may render the drawings unreadable. Timing diagrams are not made with an exact scale for showing details that cannot be shown otherwise.

In the present document, it will be referred to active signal, inactive signal, high level, low level, level "1" and level "0". As well known by a person skilled in the art, levels "0" and "1" and a low or a high level can arbitrarily correspond to an active and inactive levels depending on the kind of transistor used or of simple choice of the designer. So, changing a high level to a low level or a level "1" to a level "0" has no importance in relation with the invention.

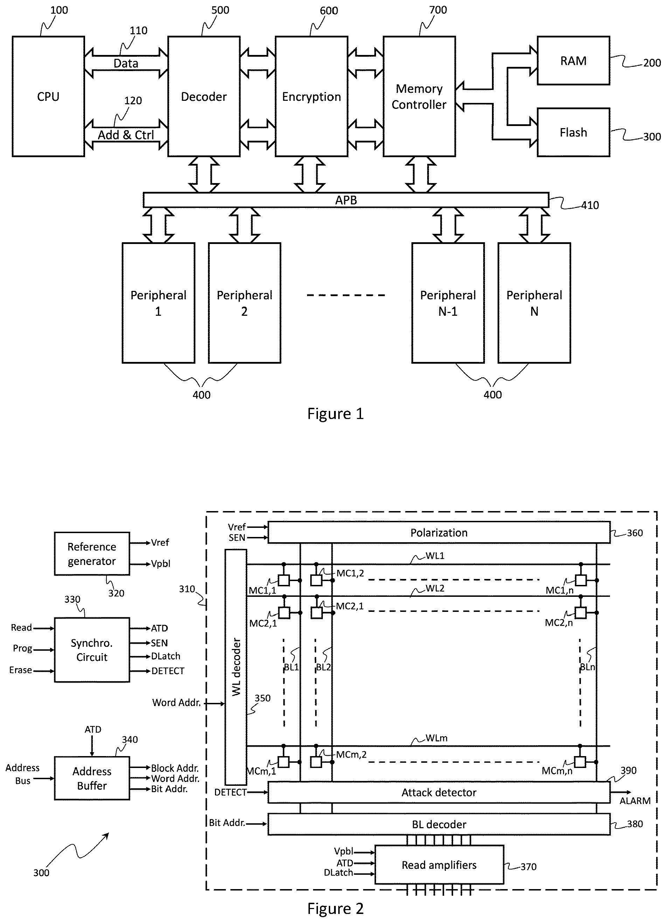

The invention is related to the security of a non-volatile memory. Such non-volatile memories are generally included in a microcontroller circuit that can be also known as System-On-Chip (SOC). As an example, a microcontroller is shown on figure 1 for showing the context of use of a memory according to the invention. The microcontroller of figure 1 comprises a central processing unit (CPU) 100 that may include one or more microprocessor cores. The CPU 100 comprises a data bus 110, and an address and control bus 120 for communicating with memories 200 and 300 and with peripheral units 400. For securely managing the memories 200 and 300 or the peripheral units 400, the microcontroller can comprise a decoder circuit 500, an encryption circuit 600 and a memory controller 700, both connected to the data bus 110 and the address and control bus 120 and to an application peripheral bus 410 for connecting the peripheral units 400.

Typically, control signals and address format depend on the memory type, and it is necessary to adapt them to be transparent for the CPU. The memory controller 700 can be used for addressing each memory 200 or 300 with address and control signals adapted to each type of memory that can be volatile memory 200, for example of RAM type, or non-volatile memory, for example of Flash type.

The encryption circuit 600 can be used for secure circuit, it can be of different type and can be controlled by the CPU for encrypting the data transmitted to the memories or to the peripheral units or for scrambling the addresses of the data into one memory. The encryption circuit 600 can be also transparent if no security is required for the transferred data.

The decoder circuit 500 can be used for decoding some control signals of the CPU in such a way to address the memories 200 or 300, one peripheral unit 400, or to control the encryption circuit 600 or for establishing a data transfer between one of the memories 200 or 300 and one peripheral unit 400, eventually through the encryption circuit 600.

Many other architectures are possible using different communication paths between a CPU, its memories, and its peripherals units. Figure 1 showing only one example amongst many other possibilities, many functional variants of the decoder circuit 500, the encryption circuit 600, and the memory controller 700 are possible and they can be also optional. For the invention, one important thing is that a CPU 100 is connected directly or indirectly to a non-volatile memory 300 in view to read data that can be encrypted or scrambled or not. According to the invention the non-volatile memory 300 is capable to send a signal to the CPU 100 for indicating when an attack has been made during a reading operation.

The figure 2 illustrates an example of a non-volatile memory 300 according to the invention, for example a Flash memory, having a size that is small enough to be implemented into a SOC. The memory 300 can comprise one or more memory blocks 310 but only one is represented for simplifying the drawing. The memory further comprises a reference generator 320, a synchronization circuit 330 and an address buffer 340 for synchronizing the memory. For simplification reasons, only signals used for a reading operation are indicated on the drawing.

The memory block 310 comprises a plurality of word lines WL1 to WLm, a plurality of bit lines BL1 to BLn and a plurality of memory cells MC1,1 to MCm,n, each memory cell MCj-i being located and connected at the intersection of one word line WLj with one bit line BLi. The memory block 310 further comprises a word line decoder 350, a polarization circuit 360, read amplifiers 370, a bit line decoder 380 and an attack detector 390.

The reference generator 320 provides a first reference voltage Vref and a second reference voltage Vpbl. The reference generator 320 contains a stabilized current source and the first reference voltage Vref corresponds to the intermediate voltage of a current mirror which is provided to the polarization circuit 360 for enabling the polarization circuit 360 to mirror and to provide this stabilized current to each bit line BL1 to BLn in such a way to polarize said bit lines BL1 to BLn with a constant current. The second reference voltage Vpbl corresponds to a preload voltage of the bit line used for starting each reading operation.

The synchronization circuit 330 receives the external control signals provided by the memory controller 700 which correspond to a reading signal Read, a programing signal Prog and an erasing signal Erase. Each of these signals Read, Prog and Erase triggers a sequence of signals to the different circuits constituting the memory circuit 300 for providing the requested operation. In the present specification, only the signals used for a reading operation will be detailed. The activation of the reading signal Read triggers an address validation signal ATD, a sensing signal SEN, a data latching signal Dlatch and an attack detection signal DETECT with timing detailed later in this document. The address validation signal ATD is provided to the address buffer 340 and to the read amplifier 370. The sensing signal SEN is provided to the polarization circuit 360. The data latching signal Dlatch is provided to the read amplifiers 370. The attack detection signal DETECT is provided to the attack detector 390.

The address buffer 340 receives the address of the data to be read from an address bus connected to the memory controller 700. The address can be multiplexed by the CPU 100, and can be demultiplexed by said memory controller, as well known by a person skilled in the art. In this document, the full address is received in parallel by the address buffer 340 from the memory controller 700. The address buffer 340 memorizes the full address at the beginning of the read operation triggered by the address validation signal ATD and till the end of the read operation for providing different address segments to several elements of the memory 300. A first segment is the block address that controls the powering of the memory block into which the reading operation is to be performed. A second segment is the word address which is sent to the word line decoder 350 for selecting one word line WLj. A third segment is the bit line address which is sent to the bit line decoder 380 for selecting one or more bit lines that correspond to the read data, depending on the number of bits that are corresponding to a data word.

The word line decoder 350 is a demultiplexer circuit that provides an active level to one word line WLj corresponding to the word address provided by the address buffer 340 while the other word lines are at an inactive level. The word line decoder 350 selects the reading of all the memory cells MCj, 1 to MCj,n connected to the selected word line WLj.

The polarization circuit 360 provides a same and constant current to all the bit lines BL1 to BLn when the sensing signal SEN is active. The constant current polarizes the bit lines BL1 to BLn and participates to the charging and discharging of said bit line BL1 to BLn during the reading of the memorized value of the selected memory cells MCj,1 to MCj,n connected to the bit lines BL1 to BLn.

The read amplifiers 370 comprise amplification circuits connected to bit lines for reading the value of selected cells after a reading time. In view to read the value, the read amplifiers 370 charge the bit line to the second reference voltage Vpbl under the control of the address validation signal ATD. Then, the bit lines are charged or discharged during a reading time, and the read values are latched by the data latching signal Dlatch.

The bit line decoder 380 is a multiplexer connected between the read amplifiers 370 and the memory cells MCj,i for selecting the bit lines to be read. With such a selection of bit lines, the number of read amplifiers 370 can be reduced to the number of bits of a data word instead of having as many amplifiers as bit lines. Such a selection can also enable to reduce the size of the polarization circuit 360 and the size of the attack detector 390.

The attack detector 390 is connected in parallel to the bit lines BL1 to BLn for sensing the voltage level to detect an abnormal voltage in such a way to determine if a photoelectric or radiative attack is occurring.

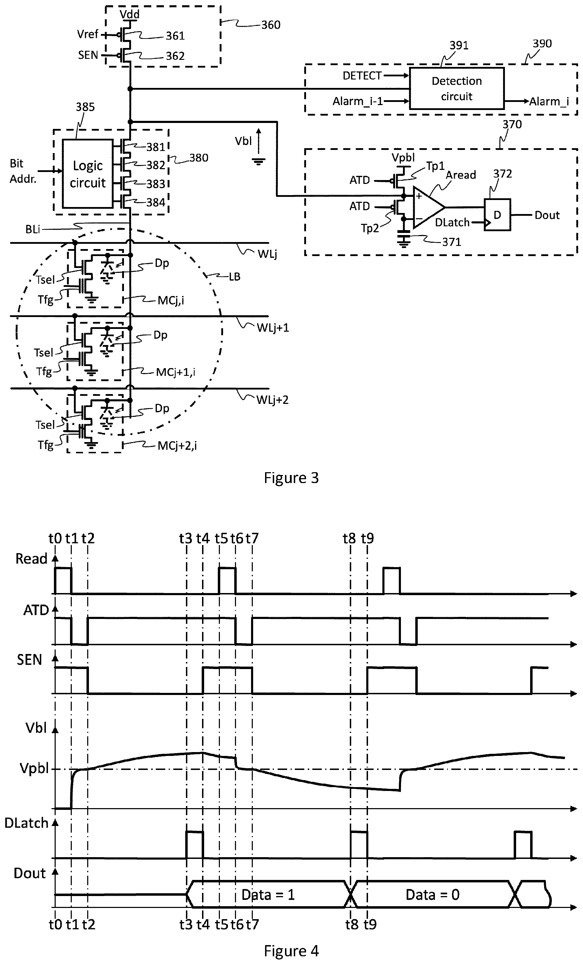

Other memory structures can implement the invention. The place of the element can be moved for optimizing the placing without changing the function. In view to explain how is made a reading operation with and without attack, the figure 3 details the different elements of the memory 300 in relation with one bit line BLi.

As it can be seen on the figure 3 the elements of figure 2 are not located at the same places and enable to reduce the size of the polarization circuit 360 and of the attack decoder 390.

For simplifying the drawings, only three word lines WLj, WLj+1 and WLj+2 are represented but, as well known by a person skilled in the art, the number m of word lines is much higher, for example m can be equal to 2¹⁰. The polarization circuit 360, the read amplifiers 370, the bit line decoder 380 and the attack detector 390 are limited to their components connected only to one bit line BLi.

The bit line decoder 380 comprises decoding transistors 381 to 384 serially mounted between the selected bit line BLi and the read amplifiers 370. The bit line decoder 380 comprises a logic circuit 385 that decodes the bit line address for controlling said decoding transistors 381 to 384. A person skilled in the art will understand that the polarization circuit 360, the read amplifiers 370 and the attack detector 390 are also connected to other bit lines through other decoding transistors (not shown) that are unselected by the bit line decoder 380. In addition, the polarization circuit 360, the read amplifiers 370, the decoding transistors 381 to 384 and the attack detector 390 are repeated for each group of bit lines corresponding to another bit of the data which is read simultaneously.

As it can be seen on figure 3, the polarization circuit 360 comprises a mirror transistor 361 and a sensing transistor 362. The mirror transistor 361 is identical to a transistor located into the reference generator 320 for mirroring a reference current used for polarizing the bit line BLi at a constant current. The sensing transistor 362 is driven by the sensing signal SEN in such a way to provide the constant current to the bit line BLi only when the sensing signal SEN is active at a low level.

The read amplifiers 370 comprise a differential amplifier Aread, first and second preload transistors Tp1 and Tp2, a capacitor 371 and a latch 372 of D type. The differential amplifier Aread comprises two inputs and provides at its output a signal corresponding to the amplified difference between its inputs. A drain of first preload transistor Tp1 and a source of the second preload transistor Tp2 are connected to one of the inputs of the differential amplifier Aread. A drain of the second preload transistor Tp2 is connected to the other of the inputs of the differential amplifier Aread. A source of the first preload transistor Tp1 is connected to the reference generator for receiving the second reference voltage Vpbl. The capacitor 371 is connected between the drain of the second preload transistor Tp2 and the ground of the memory circuit 300. The gates of the first and second preload transistors Tp1 and Tp2 both receive the address validation signal ATD for charging the capacitor 371 and the bit line BLi to the second reference voltage Vpbl when the address validation signal ATD is active. The latch 372 is connected at the output of the differential amplifier Aread for latching the read data under the control of the data latching signal Dlatch.

Each memory cell MCj,i comprises a floating gate transistor Tfg and a selection transistor Tsel. A gate of the selection transistor Tsel is connected to the word line WLj. A drain of the selection transistor Tsel is connected to the bit line BLi. A source of the selection transistor Tsel is connected to the drain of the floating gate transistor Tfg. A source of the floating gate transistor Tfg is connected to a ground voltage. The gate of the floating gate transistor Tfg is used for erasing and programming the bit memorized by the floating gate transistor and can be unconnected or can be polarized with a reading voltage for adjusting the current in the memory cell MCj,i during the reading operation. The memory cell MCj,i memorizes a bit value corresponding to a quantity of charges accumulated in the floating gate of the floating gate transistor Tfg. The value "0" or "1" of a memorized bit can be arbitrarily associated to the fact that the floating gate is charged or discharged. In the present document the bit value "0" corresponds to charged floating gate.

In addition, the selection transistor Tsel of each cell being a N-channel transistor made on a P-substrate, a parasitic diode Dp is reverse connected between the bit line BLi and the ground voltage. This parasitic diode Dp is normally always blocked and corresponds electrically to a small capacitor. The small capacitor multiplied by the number of memory cells MCj,i connected to the bit line Bli defines the total capacitance of the bit line Bli.

The person skilled in the art knows that such kind of memory is sized to be small with a low consumption. The size of the transistors constituting the memory cells MCj,i limits the current flowing through the memory cells and defines the global capacitance of the bit line Bli. As an example, the transistor can be sized for enabling to pass a current of 10 µA, while the polarization circuit 360 provides a constant current of 5 µA, in such a way that the bit line can be charged or discharged with a current of +/- 5 µA. The time for totally charging or discharging the bit line BLi depends on the number of cells connected to the bit line and can be around 40 ns for a complete charging with 2¹⁰ memory cells connected to one bit line. For preloading the bit line, the first preload transistor Tp1 (which are in lower number than memory cells) can be much larger for reducing the preload time for example to 2 ns.

Before detailing the functioning of the attack detector 390, a normal reading operation is detailed in relation to figure 4. For reading a data word, the address bus of the non-volatile memory 300 should be charged by the memory controller 700 with an address corresponding to a data word to be read, as an example the data word to be read comprises a bit located in the memory cell MCj,i. Then the memory controller 700 activates the reading signal Read at time t0 for indicating to the non-volatile memory 300 that a read operation must be performed. In response to the reading signal Read, the synchronization circuit 330 activates the address validation signal ATD at a time t1 till a time t2. As an example, time t1 can be set 2 ns after time t0 and time t2 can be set 2 ns after time t1. The activation of the address validation signal ATD causes the address buffer 340 to memorize the address at time t1. The address buffer 340 provides immediately at the time t1 the block address to switch on the selected memory block, and the bit address corresponding to the bit line BLi for connecting the selected bit line BLi through the decoding transistors 381 to 384.

During the activation of the address validation signal ATD, the first and second preload transistors Tp1 and Tp2 are switched on and the bit line BLi is preloaded to the second reference voltage Vpbl. It should be noted by the person skilled in the art that the channel width of the first preload transistor Tp1 must be sized for driving the bit line voltage at the second reference voltage Vpbl before the time t2.

At time t2, the address buffer 340 provides the word address that selects the word line WLj. The selection transistor Tsel of memory cell MCj,i switches to a conducting state at this moment.

At time t2, the synchronization circuit 330 deactivates the address validation signal ATD and activates sensing signal SEN. The deactivation of the address validation signal ATD blocks the first and second preload transistors Tp1 and Tp2. The activation of the sensing signal SEN connects the mirror transistor 361 to the bit line BLi through the sensing transistor 362. Considering that the floating gate of the floating gate transistor Tfg of memory cell MCj,i is discharged, the floating gate transistor Tfg of the selected memory cell MCj,i is in open circuit. The stabilized current provided by the mirror transistor 361 can charge the capacitance of the bit line BLi, increasing the bit line voltage Vbl.

At time t3, the synchronization circuit 330 activates the data latching signal Dlatch. The bit line BLi being at a voltage higher than the second reference voltage Vpbl memorized by the capacitor 371, the output of the differential amplifier is at high level, and the latch 372 memorizes and provides at its output a bit value equal to "1". It should be noted that the time t3 is set to a value corresponding to a time sufficient for significatively charging or discharging the bit line for having a good reading of the cell level, but it is not necessary to wait a complete charging or discharging of the bit line. As an example, time t3 can be set to 20 ns after time t2 for warranting that the charging or discharging of bit line enables to have a good reading whatever the wear of the floating gate transistors. At a time t4, after time t3, for example 1 ns later, the synchronization circuit 330 deactivates the sensing signal SEN and a new reading operation can be initiated by the memory controller 700, presenting a new address, as an example the data to be read comprises a bit located in the memory cell MCj+1,i and containing a "0" value. The memory controller 700 activates the reading signal Read at time t5 for indicating to perform a new read operation. In response, the synchronization circuit 330 activates the address validation signal ATD at a time t6 till time t7.

The first and second preload transistors Tp1 and Tp2 preload the bit line BLi at the second reference voltage Vpbl before the time t7. At time t7, the address buffer 340 provides the word address that selects the word line WLj+1. The selection transistor Tsel of memory cell MCj+1,i switches to a conducting state at this moment.

At time t7, the synchronization circuit 330 deactivates the address validation signal ATD and activates sensing signal SEN. The deactivation of the address validation signal ATD blocks the first and second preload transistors Tp1 and Tp2. The activation of the sensing signal SEN connects the mirror transistor 361 to the bit line BLi through the sensing transistor 362. Considering that the floating gate of the floating gate transistor Tfg of memory cell MCj+1,i is charged, the floating gate transistor Tfg of the selected memory cell MCj,i is in a conducting state. The stabilized current provided by the mirror transistor 361 is driven to the ground together with the charges of the bit line BLi, decreasing the bit line voltage Vbl.

At time t8, the synchronization circuit 330 activates the data latching signal Dlatch. The bit line BLi being at a voltage lower than the second reference voltage Vpbl memorized by the capacitor 371, the output of the differential amplifier is at low level, and the latch 372 memorizes and provides at its output a bit value equal to "0". Another read operation can be performed after a time t9 corresponding to a deactivation of the sensing signal SEN.

A laser attack can be made on the memory cells for introducing reading errors during a reading operation in such a way to introduce errors inside an algorithm for cracking a code. As shown on figure 3, a laser beam LB lights several memory cells MCj,i to MCj+2,i. The effect of the laser beam LB on lighted memory cells MCj,i to MCj+2,i is to make passing the parasitic diode Dp, creating a short circuit on the bit line BLi driving the voltage of the bit line BLi to the ground voltage.

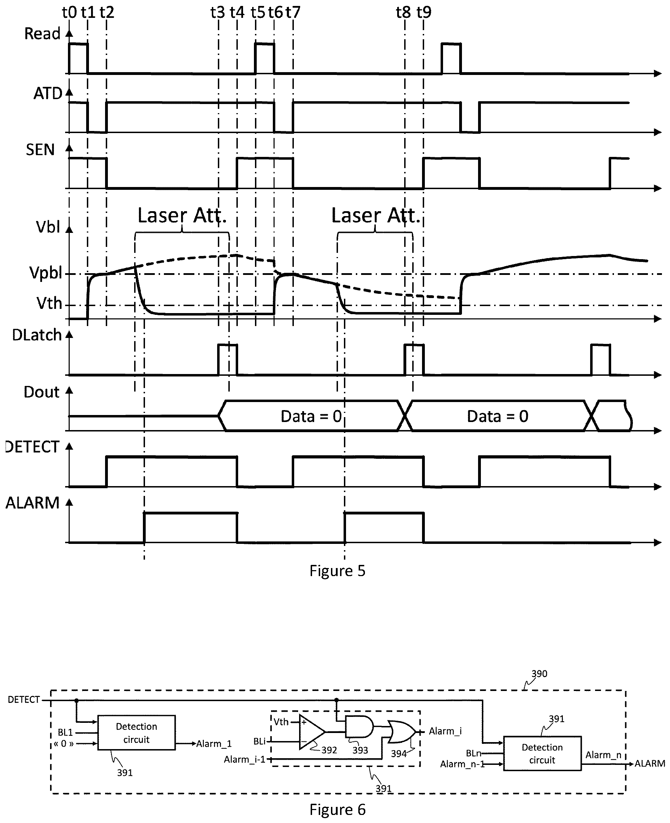

To be efficient, a laser attack is synchronized with a read operation. The hacker must synchronize the laser attack with the sensing signal in such a way that the laser attack occurs after the preload of the bit line BLi, as shown on figure 5. The laser attack occurs after time t2 and is maintained till time t3 in such a way the bit line is driven to the ground voltage during the charging or the discharging of the bit line by the selected memory cell MCj,i. The driving being made by one or more parasitic diodes Dp, the current is more important than a simple read operation and the bit line voltage Vbl is quickly driven close to the ground voltage. The result of the attack is that the latch 372 memorizes and provides systematically at its output a bit value equal to "0", whatever the state of the floating gate transistor Tfg of the selected memory cell MCj,i.

For detecting such a laser attack, the attack detector 390 comprises a detection circuit 391 connected to the bit line BLi. The figure 6 details a first embodiment of an attack detector 390. The attack detector 390 can comprises as many detection circuits 391 as bit lines BLi but it is possible to have a lower number of detection circuits 391 if the detection circuit 391 is connected to the bit line BLi through the bit line decoder 380. Each detection circuit 391 comprises a first input connected to the bit line BLi for detecting an abnormal voltage, a second input for receiving the attack detection signal DETECT and an output for providing an alarm signal Alarm_i. The attack detection signal DETECT is used for activating the detection for example only when the sensing signal SEN is active.

If the attack detector 390 comprises several detection circuits 391, each detection circuit 391 can have a third input for receiving the output of a previous detection circuit 391 for chaining the alarm signal Alarm_i from a first to a last detection circuit 391. In that case, the third input of a first detection circuit 391 receives an inactive signal, for example a "0". The third input of each other detection circuit 391 is connected to the output terminal of a previous detection circuit 391 for receiving its alarm signal Alarm_i-1. The output of a last detection circuit 391 corresponds to an output of the attack detector 390 and provides a global alarm signal ALARM.

In the first embodiment of figure 6, each detection circuit 391 comprises a comparator 392, an AND-gate 393 and an OR-gate 394. The comparator 392 has two inputs and one output, the first input being connected to the bit line BLi associated to said detection circuit 391 and the other input receiving a reference voltage Vth. The comparison aims at detecting if the bit line voltage is abnormal or not. As it can be seen on figure 5, the bit line voltage falls close to the ground voltage during a laser attack. In a normal reading operation, the bit line voltage can fall to a minimum voltage when the memory cell discharges the bit line BLi, but this minimum voltage is not close to the ground voltage. So, a comparison of the bit line voltage with a threshold voltage Vth can enable to detect an abnormal voltage of the bit line when the bit line voltage is lower than the threshold voltage Vth. Of course, the threshold voltage Vth must be fixed at a voltage value lower than the minimum voltage that can be reached by the bit line during a normal reading operation. The AND-gate 393 can have two inputs, one connected to the output of the comparator 392 and the other receiving the attack detection signal DETECT for validating the comparison made by the comparator 392 only when the attack detection signal DETECT is active. The OR-gate 394 can have two inputs, one input being connected to the output of the AND-gate 393 and the other input corresponding to the third input of the detection circuit 391 for providing the alarm signal Alarm_i detected by the comparator 392 or for cascading the alarm signal Alarm_i-1.

As it can be seen on the figure 5, the detection circuit 391 of figure 6 can detect a laser attack whatever the bit value memorized by the memory cell. So, the use of a simple comparison to the voltage threshold appears to be the easiest solution to implement. As an example, for a memory circuit having a power supply voltage of 2 volts, the second reference voltage Vpbl can be 1 volt and the lowest voltage value that can be reached by the bit line during a normal reading operation can be higher than 0,4 volts. So, the threshold voltage can be set to 0,3 Volts which is easy to implement.

But for a memory having a very low power supply, for example 1,2 Volts, the lowest voltage value that can be reached by the bit line during a normal reading operation can be relatively low, for example 0,15 Volts. In such a memory circuit, it is necessary to have a threshold voltage around 0,1 Volts. Making such a reference voltage is relatively difficult to implement because it necessitates to have a complex voltage generator that can take a large place into the memory circuit.

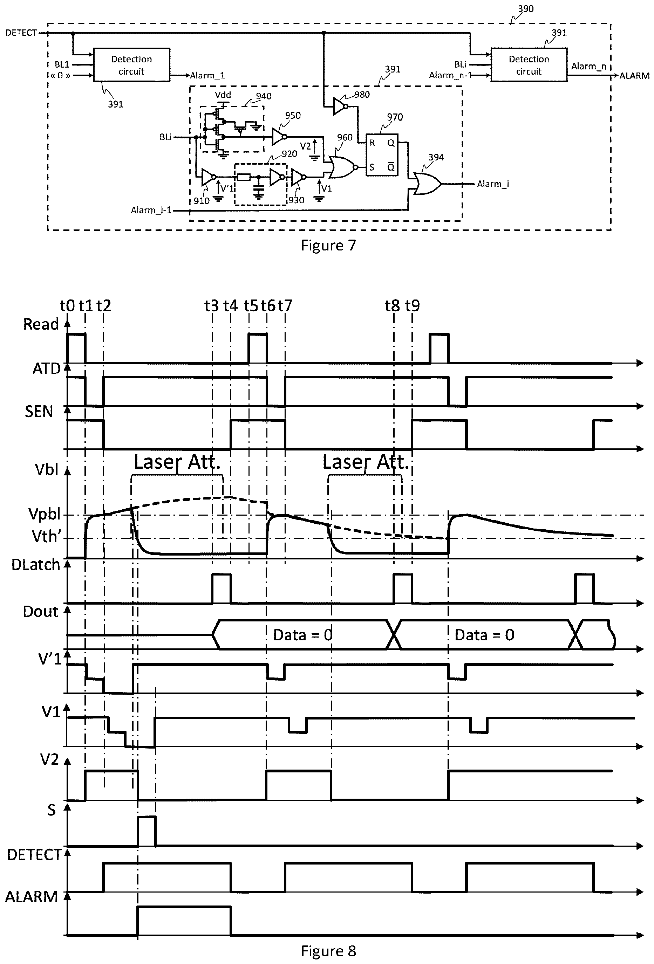

A second embodiment of the attack detector 390 is shown on figure 7 and its functioning will be detailed in relation with the timing diagram of figure 8. The attack detector 390 of figure 7 principally differs from the attack detector of figure 6 in that the detection circuits 391 comprises a slope detector. The slope detector of the detection circuit 391 can be of any type allowing to detect when a decrease of the bit line voltage Vbl is very fast and corresponds to an abnormal situation corresponding to a laser attack. The figure 7 details an example of realization of a slope detector which is simple and enable to make such a detection.

The slope detector comprises a first branch and a second branch both connected to the bit line BLi. The first branch comprises a first inverter 910 having its input connected to the bit line BLi and serially connected to a delay circuit 920 and to a second inverter 930. The delay circuit 920 can be constituted of an RC circuit coupled to an inverter, the RC circuit being sized for introducing a delay in the commutation time of said inverter. With the delay circuit 920, the voltage V1 at the output of the second inverter 930 corresponds to the voltage V'1 at the output of the first inverter delayed by the delay of the RC circuit. The second branch comprises a third inverter 940 having its input connected to the bit line BLi and serially connected to a fourth inverter 950. The third inverter 940 is an inverter having an input threshold shifted down in such a way its commutation is made at a threshold voltage Vth' lower than the normal threshold of an inverter, which is equal to the second reference voltage Vpbl. The slope detector comprises a NOR-gate 960 with two inputs, one input connected to the output of the first branch and the other input connected to the output of the second branch. An SR-latch 970 has its set input S connected to the output of the NOR-gate 960 and receives the attack detection signal DETECT through a fifth inverter 980 on its reset input R in such a way the SR latch 970 is reset each time the attack detection signal DETECT is inactive.

The detection circuit 391 of figure 7 comprises an OR-gate 394 having two inputs, one input being connected to the output of the SR-latch 970 and the other input corresponding to the third input of the detection circuit 391 for providing the alarm signal Alarm_i provided by the SR-latch 970 or for cascading the alarm signal Alarm_i-1.

As indicated on figure 8, the read operation is initiated by the memory controller 700 at time t0. The synchronization circuit 330 activates the address validation signal ATD at a time t1 and the bit line voltage Vbl is preloaded at the second reference voltage Vpbl by the first preload transistor Tp1. The second reference voltage Vpbl being equal to a threshold of the first inverter 910, the voltage V'1 at the output of the first inverter 910 is set to the threshold voltage. The threshold of the third inverter 940 being lower than the second reference voltage Vpbl, the output of the first inverter is set to a low level and the voltage V2 at the output of the fourth inverter is set to a high level.

At time t2, the bit line voltage increases causing the voltage V'1 at the output of the first inverter 910 to be set at low level, while the voltage V2 at the output of the fourth inverter 940 remains to a high level.

When the laser attack occurs, the bit line voltage Vbl quickly falls, crossing down the threshold of the first inverter 910 and the voltage threshold Vth' of the third inverter 940 with a short delay. The voltage V'1 at the output of the first inverter 910 is set to high level, while the voltage V2 at the output of the fourth inverter 940 is set to low level. The voltage V1 at the output of the second inverter 930 being delayed by the RC circuit remains at low level causing the two inputs of the NOR gate to be at low level during a time corresponding to the difference between the delay introduced by the RC circuit and the falling time of the bit line voltage from the second reference voltage Vpbl to the voltage threshold Vth'. So, the set input S of the SR-latch 970 becomes active and sets the output of the SR-latch 970 to high level, activating the alarm signal ALARM. Typically, the delay of the RC circuit should be determined to be a reference slope for the decrease of the bit line from the second reference voltage Vpbl to the voltage threshold Vth', and an abnormal situation is detected when the bit line voltage decreases with a slope faster than this reference slope.

The person skilled in the art can also remark on figure 8 that the slope detector does not detect the laser attack occurring after time t7 because the bit line voltage corresponds to the reading of a bit that decreases the bit line voltage. The absence of detection of laser attack is not a problem because the read bit is not affected by the laser attack and the attack does not introduce a reading error.

Many variants of the disclosed slope detector are possible. The second and fourth inverters 930 and 950 can be suppressed and the NOR-gate 960 can be replaced by a NAND-Gate for a same result. The first and third inverters 910 and 940 can be replaced by another type of logic gate, the important is to have a shifted input threshold on one branch and to have a delay on the other branch for detecting that the falling slope is faster than in a normal situation. The SR-latch 970 can also be replaced by another kind of latch depending on the type of logic gate replacing the NOR-gate 960.

The use of such an alarm signal ALARM enables to alert the CPU 100 that a reading operation has been corrupted. So, the CPU can abort the running program and can restart the program at the beginning or simply reboot its operating system.

The invention is not limited by the example described in the present specification. In particular, the memory circuit could be not integrated inside a microcontroller or a SOC but could be a memory circuit connected to an external CPU. The alarm signal can be used for other purposes than restarting the CPU.

In addition, as previously indicated, the reference to levels "0" and "1" and a low or a high level can arbitrarily correspond to active and inactive levels depending on the kind of transistor used or of simple choice of the designer. So, changing a high level to a low level or a level "1" to a level "0" has no importance in relation with the invention.

## Claims

1. A method for detecting a reading error caused by a photoelectric or radiative attack of a non-volatile memory having memory cells (MCj,i) connected to at least one bit line (BLi), and comprising each a floating gate transistor (Tfg), wherein a reading of a memory cell (MCj,i) is made by pre-charging a bit line (BLi) to a preload voltage (Vpbl) and comparison of the bit line voltage (Vbl) to this preload voltage (Vpbl) after a reading time during which a selected cell (MCj,i) charges or discharges the bit line (BLi) polarized by a constant current, **characterized in that** the detection of a reading error is made by detection of an abnormal bit line voltage (Vbl), and wherein an alarm signal (ALARM) is provided when an abnormal bit line voltage is detected.

2. The method of claim 1, wherein the abnormal bit line voltage is detected by comparison of the bit line voltage (Vbl) to a threshold voltage (Vth), said threshold voltage (Vth) being a constant voltage lower than the minimum voltage that can be reached by the bit line (BLi) during a normal reading operation, and wherein the abnormal bit line voltage is detected when the bit line voltage (Vbl) is lower than the threshold voltage (Vth).

3. The method of claim 1, wherein the abnormal bit line voltage is detected when the bit line voltage (Vbl) decreases with a slope faster than a reference slope.

4. A non-volatile memory circuit (300) comprising a plurality of memory cells (MC1,1 to MCm,n), a plurality of bit lines (BL1 to BLn) and a plurality of word lines (WL1 to WLm), each memory cell (MCj,i) comprising a floating gate transistor (Tfg) for memorizing a bit value and being located at the intersection of a bit line (BLi) and of a word line (WLj), said non-volatile memory circuit (300) comprising a polarization circuit (360) for polarizing the bit lines (BLi) with a constant current, and reading amplifiers (370) connected to bit lines (BLi) for reading the value of memory cells (MCj,i) selected by one of the word lines (WLj), **characterized in that** it further comprises an attack detector (390) comprising at least one detection circuit (391) having a first input terminal connected to at least one bit line (BLi) for detecting an abnormal voltage on the bit line (BLi) and for providing an alarm signal (ALARM) on an output terminal when the abnormal voltage is detected.

5. The non-volatile memory circuit of claim 4, wherein the detection circuit (391) comprises a second input terminal receiving a validation signal (DETECT), and wherein the alarm signal (ALARM) is provided only if the validation signal is activated.

6. The non-volatile memory circuit of claim 4 or 5, wherein the attack detector (390) comprises a plurality of detection circuits (391), wherein each detection circuit (391) comprises a third input terminal, the third input terminal of a first detection circuit (391) receiving an inactive signal ("0"), the third input terminal of each other detection circuit (391) being connected to an output terminal of a previous detection circuit (391), and wherein an output terminal of a last detection circuit (391) corresponds to an output terminal of the attack detector (390), in such a way that if one of the detection circuits (391) provides an alarm signal (Alarm_i), this alarm signal (ALARM) is cascaded to the output terminal of the attack detector (390).

7. The non-volatile memory circuit according one of the claims 4 to 6, wherein the detection circuit (391) comprises a comparator (392) having two inputs and one output, one of the inputs being connected to the first input terminal and the other input receiving a threshold voltage (Vth) which is a constant voltage lower than the minimum voltage that can be reached by the bit line (BLi) during a normal reading operation, and wherein an abnormal voltage is detected when the bit line voltage (Vbl) is lower than the threshold voltage (Vth).

8. The non-volatile memory circuit according one of the claims 4 to 6, wherein the detection circuit (391) comprises a slope detector, and wherein an abnormal voltage is detected when the bit line voltage (Vbl) decreases with a slope faster than a reference slope.

9. The non-volatile memory circuit of claim 8, wherein the slope detector comprises :
- a first branch comprising at least a first logic circuit (910) having an input connected to the bit line (BLi) and having a first input threshold (Vpbl), a delay circuit (920) connected to the output of the first logic circuit (910) for delaying a transition of the first logic circuit (910), and
- a second branch comprising at least a second logic circuit (940) having an input connected to the bit line (BLi) and having a second input threshold (Vth') lower than the first input threshold (Vpbl),
- a third logic circuit (960) having one input connected to an output of the delay circuit (920) and another input connected to an output of the second logic circuit (940), an output of the third logic circuit (960) being active when a transition at the output of the second logic circuit (940) occurs before a transition at the output of the delay circuit (920), and
- a latch circuit (970) connected to the output of the third logic circuit (960) for providing the alarm signal (Alarm_i, ALARM) in response to activation of the output of the third logic circuit (960).

10. The non-volatile circuit of claim 9 depending on claim 5, wherein the latch circuit (960) is reset when the validation signal (DETECT) is inactive.
